# EUROPEAN PATENT SPECIFICATION

(11) **EP 2 238 620 B1**
(45) Date of publication and mention of the grant of the patent: **24.08.2011**
(21) Application number: 09731078.3
(22) Date of filing: 20.01.2009
(51) Int. Cl.: H01L 23/498

(54) **EMBEDDED CONSTRAINER DISCS FOR RELIABLE STACKED VIAS IN ELECTRONIC SUBSTRATES**
EINGEBETTETE RÜCKHALTESCHEIBEN FÜR ZUVERLÄSSIGE STAPELPFADE IN ELEKTRONISCHEN SUBSTRATEN
DISQUES DE CONTRAINTE INCORPORES POUR DES TROUS D'INTERCONNEXION EMPILES DE MANIERE FIABLE DANS DES SUBSTRATS ELECTRONIQUES

(30) Priority: 27.01.2008 US 20561
(43) Date of publication of application: 13.10.2010
(73) Proprietor: International Business Machines Corporation, Armonk, NY 10504 (US)
(72) Inventor: SRI-JAYANTHA, Sri, Ossining New York 10562 (US); RUSSELL, David, John, Owego New York 13827 (US); KACKER, Karan c/0 IBM United Kingdom Limited Intellectual Property Law, inchester, Hampshire S021 2JN (GB); QUESTAD, David, Hopewell Junction New York 12533 (US); POWELL, Douglas, Oliver, Endicott New York 13760 (US)
(74) Representative: Williams, Julian David
(86) International application number: PCT/EP2009/050585
(87) International publication number: WO 2009/124785

(56) References cited:
- US-A1- 2004 256 715
- US-A1- 2007 246 254

## Description

The invention disclosed broadly relates to the field of electronic modules and more particularly relates to the field of electrical connectivity through stacked vias in electronic modules. Stacked vias are widely known, see *e.g.* US2007/0246254.

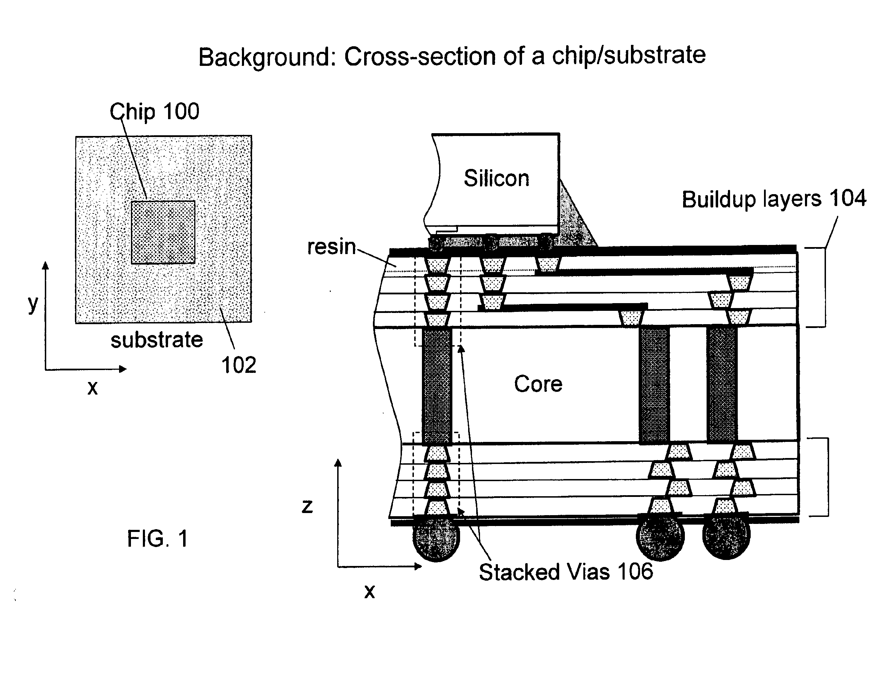

FIG. 1 shows two key components of an electronic module. The chip is made of silicon on which electronic circuits are fabricated. The substrate is made of organic materials embedded with copper interconnects. A substrate helps to join the chip to external electronic circuits on a motherboard.

The density of connection points (controlled collapse chip connection, or "C4s") between a chip and a substrate is a critical parameter. A larger number of C4s requires multiple buildup layers to achieve the needed electrical connections to the motherboard. FIG. 1 shows stacked as well as staggered vias needed to complete the interconnection. Stacked vias help achieve more than 20% connection density compared to a staggered via.

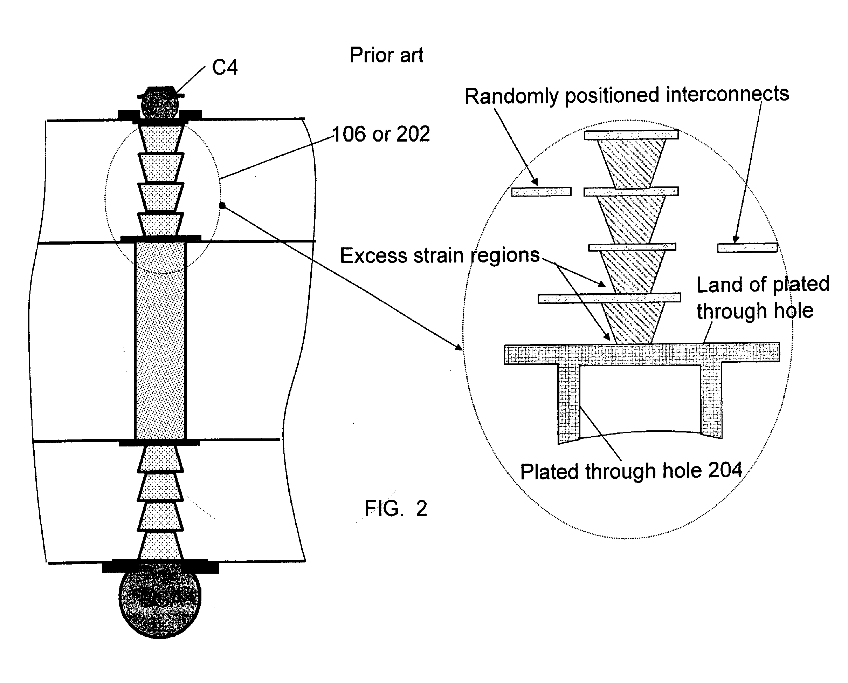

FIG. 2 shows the known art with regard to a stacked via and a plated through hole (PTH). Observe that the copper interconnects within the buildup layer surrounds the stacked via and their spatial distribution can vary randomly without any specific design rule. The coefficient of thermal expansion (CTE) of various materials used to construct a chip module is not matched and is known to drive thermomechanical stresses within the module. Repeated thermal cycling of an electronic module exhibits failure at via interface regions due to thermomechanically driven accumulated strain. A via stack is strained along the Z-axis as well as the X-Y plane by the CTE-driven thermo mechanical stresses.

In accordance with the present invention there is now provided a substrate via structure comprising: a substrate comprising:a plurality of stacked vias, wherein each via is disposed on a landing; and at least one constrainer disc surrounding at least one of the plurality of stacked vias, the at least one constrainer disc constraining in-plane deformation of the substrate via structure; characterized in that the structure comprises a dielectric gap between the constrainer disc and the via.

Viewing the present invention from another aspect, there is now provided a method for constraining in-plane deformation of a via stack, the method comprising: creating a via stack on a substrate, wherein each via is disposed on a landing; creating a constrainer disc; and embedding the constrainer disc such that it surrounds the via landing for constraining in-plane deformation of the via stack; characterized in that the embedding step further comprises creating a dielectric gap between an inner diameter of the constrainer disc and the via landing

In a preferred embodiment of the invention, a substrate via structure for stacked vias includes: a plurality of stacked vias, wherein each via is disposed on a landing; and at least one constrainer disc surrounding at least one via, for constraining in-plane deformation of the substrate via structure. The constrainer disc is embedded such that the constrainer disc is disposed between two layers of resin. The constrainer discs may be made of copper. The constrainer disc may be circular or square-shaped. Preferably there is a dielectric gap between the constrainer disc and the via.

In another preferred embodiment of the present invention, a method for constraining in-plane deformation of a via stack includes: creating a via stack on a substrate, wherein each via is disposed on a landing; creating a constrainer disc; and embedding the constrainer disc such that it surrounds the via landing.

Preferred embodiments of the invention will now be described, by way of example only, with refence to the accompanying drawings, in which:
FIG. 1 shows a basic electronic module, according to the prior art;
FIG. 2 shows the stacked via of an electronic module, according to the prior art;
FIG. 3a shows a prior art stacked via with a surrounding interconnect, according to an embodiment of the present invention;
FIG. 3b shows stacked vias with surrounding constrainer discs, according to an embodiment of the present invention;
FIG. 4 shows the mesh structure of a three-dimensional finite element model, according to an embodiment of the present invention;
FIG. 5 shows two working models of stacked vias and surrounding structures, one without constrainer discs, and one with constrainer discs;
FIG. 6a shows a top and side cross-sectional view of the constrainer discs, according to an embodiment of the present invention; and
FIG. 6b shows a side cross-sectional view of the constrainer discs, according to an embodiment of the present invention.

While the invention as claimed can be modified into alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the scope of the present invention.

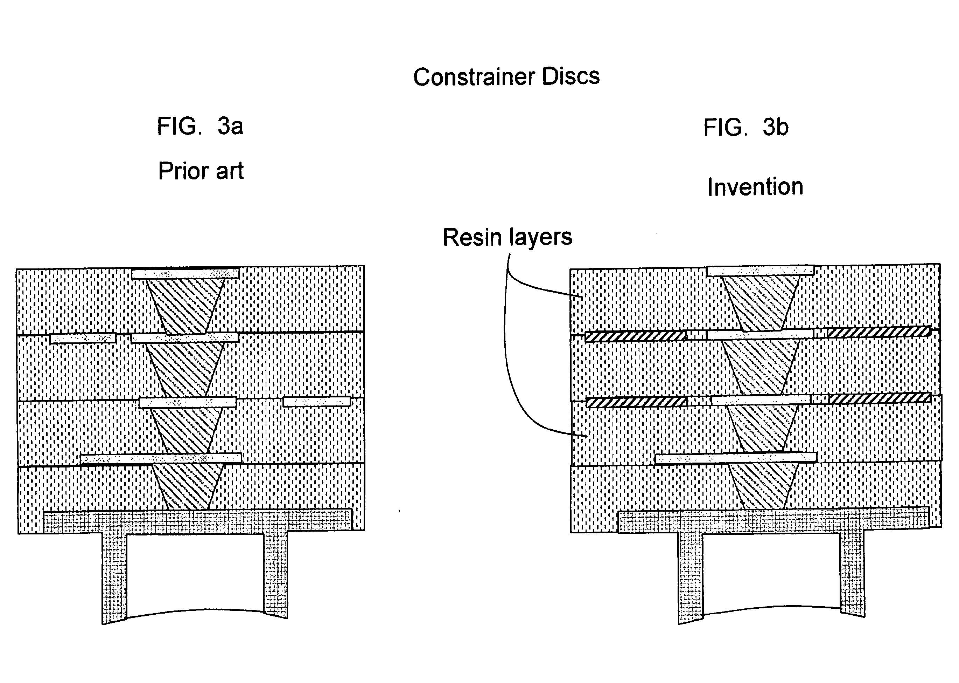

We describe an apparatus and method for constraining the in-plane deformation driven by the build-up layer surrounding a via stack. Referring now in specific detail to the drawings, and particularly FIG. 3, there is illustrated a diagram of the stacked vias of FIG. 2, with surrounding constrainer discs, according to an embodiment of the present invention. During a thermal cycle (125 degC to -55 degC) as the build up layers (CTE~30 ppm/degC) shrink along the Z axis as well as in-plane (X-Y) much faster than the Cu-via (CTE~16), a stacked via is compressed by the surrounding build-up layer. The surrounding constrainer discs reduce the amount of load applied to the stacked via by constraining the build-up layer in the X-Y direction.

Without a constrainer disc, the build-up layers that are made up of high CTE resin tend to shrink in volume much more than the copper vias. Thus, the compression during cooling or expansion during heating of the organic substrate introduces a distributed force at the interface of the copper via stack and the resin. This force is undesirable because it creates plastic strain on the via material. This strain in turn contributes to fatigue crack generation and propagation within a stacked via. By embedding constraining copper discs in the surrounding space of the stacked vias the distributed force that the resin would have generated on the via surface is commensurately reduced by sharing the surface forces between the discs and the stacked vias.

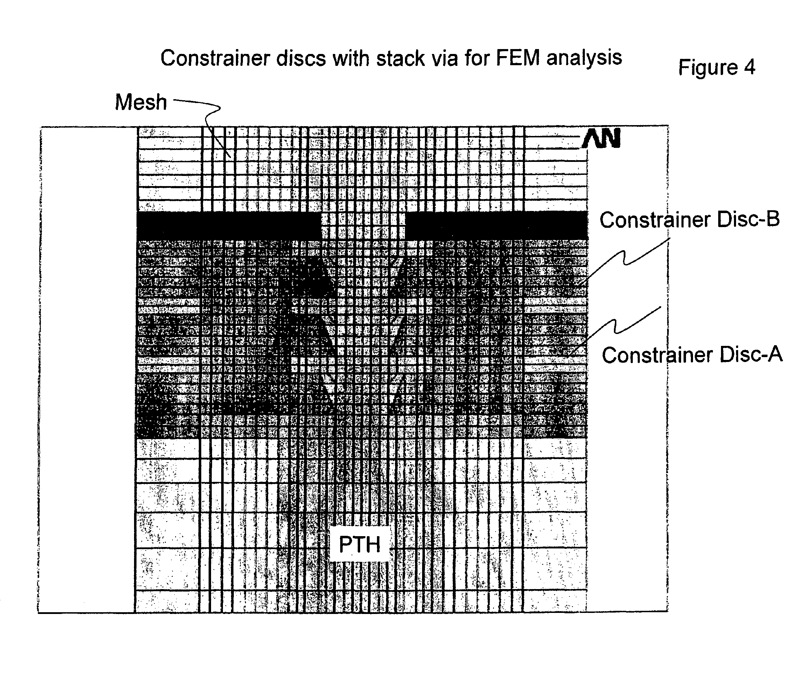

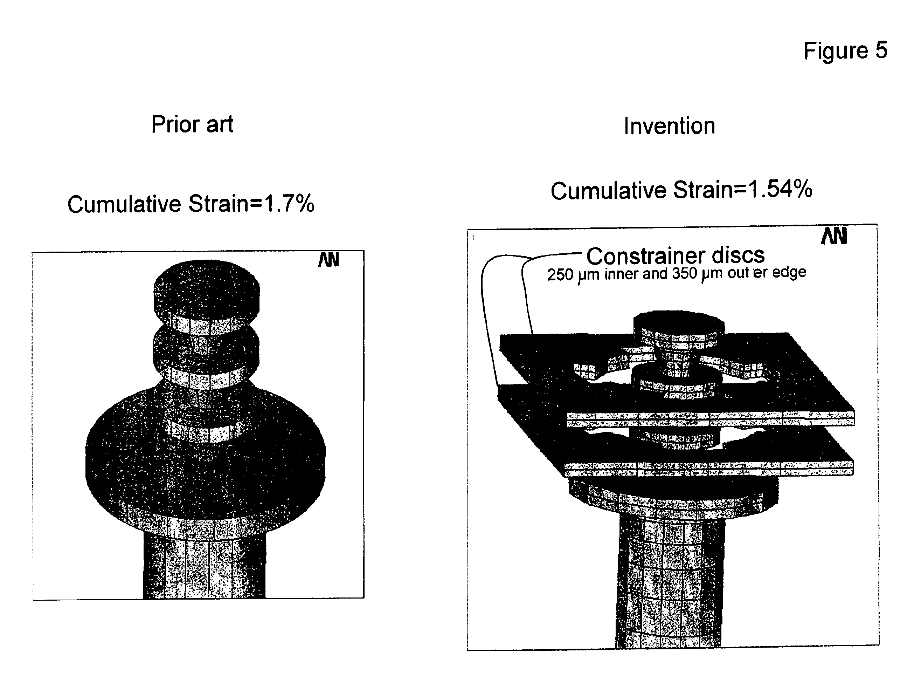

Referring to FIG. 4 there is shown a mesh structure for a three dimensional (3D) finite element model. Observe that in FIG. 4 two constrainer discs A and B are shown. The grid pattern in FIG. 4 represents the mesh structure used to formulate and solve the finite element problem. The scale of the model corresponds to a plated through hole (PTH) landing diameter of 210 µm. Two cases were next constructed (FIG. 5) and compared: 1) a via stack that has no constrainer disc around it and 2) a via stack with two constrainer discs as shown in FIG. 5. Analysis reveals that the cumulative strain of a conventional stacked via of 1.7% can be reduced to 1.54% (10% reduction) by means of a two constrainer system. Observe that the life-time of a via is non-linearly dependent on the plastic strain. Elastic strain in a material is reversible whereas a plastic strain is irreversible. When the applied stress is removed an elastic deformation reverts back to its original shape whereas a plastic strain does not. Plastic strain, when produced repeatedly due to thermal cycling, is known to generate fatigue failure in materials. Thus it is important to minimize the plastic strains encountered by critical components within an electronic assembly.

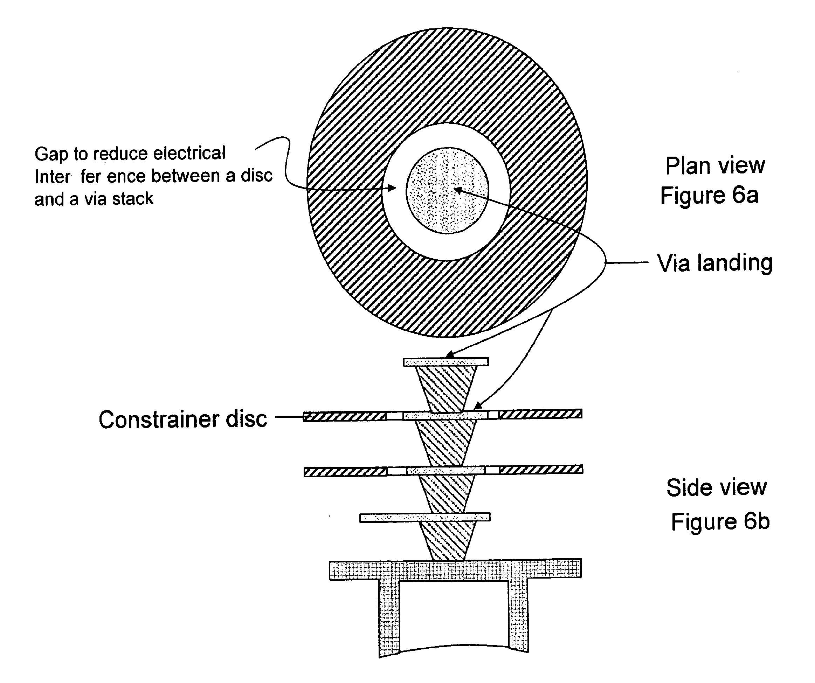

FIG. 6a shows a planar view and FIG. 6b shows a side view of a circular constrainer disc. The exact shape of the constrainer disc may have to be determined according the presence of interconnects in the vicinity of the stack via. Ideally, a circular constrainer disc would be preferable as it produces a circularly symmetric constraint, but modification of the shape may become inevitable for the reason just mentioned.. For example, when the interconnect density in the surrounding space is not high, the discs can be circular and their diameter can be increased to share more load imparted by the resin. However, if the competition for space surrounding a stacked via is high, then the disc shape needs to be tailored to fit into the available space.

Among three types of build-up layers (ground plane, voltage plane and interconnect layer) the first two have a natural planner design thereby providing the function of a constraining disc. Thus an explicit design of a constraining disc is not called for whenever there is a copper plane surrounding a via stack. However, as the number of build-up layers increase, the via stack may require an explicit design effort to embed a constrainer disc. A certain amount of interconnect design change may be required to embed a constrainer disc. Similar to interconnects, the constrainer discs are sandwiched between two layers of resin. We refer to this as being embedded.

The constrainer discs are etched using the identical subtractive process step that is used for circuitizing a layer. FIG. 6 shows a gap between the inner diameter of the constrainer disc and the via stack. This dielectric gap between a via stack and the disc must be optimized to achieve the best trade-off between parasitic electrical effects and positive mechanical constraining effect.

## Claims

1. A substrate via structure comprising:
a substrate comprising:
a plurality of stacked vias, wherein each via is disposed on a landing; and
at least one constrainer disc surrounding at least one of the plurality of stacked vias, the at least one constrainer disc constraining in-plane deformation of the substrate via structure;
**characterized in that** the structure comprises a dielectric gap between the constrainer disc and the via.

2. The structure of claim 1 wherein the constrainer disc is embedded such that the constrainer disc is disposed between two layers of resin.

3. The structure of claim 2 wherein the constrainer disc is copper.

4. The structure of claim 3 wherein the constrainer disc is substantially circular.

5. The structure of claim 3 wherein the constrainer disc is square-shaped.

6. The structure of claim 2 wherein a shape of the constrainer disc varies according to design parameters and constraints imposed by interconnects.

7. The structure of claim 1 wherein the stacked vias are copper vias.

8. A method for constraining in-plane deformation of a via stack, the method comprising:
creating a via stack on a substrate, wherein each via is disposed on a landing;
creating a constrainer disc; and
embedding the constrainer disc such that it surrounds the via landing for constraining in-plane deformation of the via stack;
**characterized in that** the embedding step further comprises creating a dielectric gap between an inner diameter of the constrainer disc and the via landing.

9. The method of claim 8 wherein the embedding step comprises disposing the constrainer disc between two layers of resin.

10. The method of claim 8 wherein creating the constrainer disc comprises creating the constrainer disc out of copper.

11. The method of claim 10 wherein creating the constrainer disc further comprises creating a circular disc.

12. The method of claim 10 wherein the step of creating the constrainer disc further comprises tailoring a shape of the constrainer disc to fit available space on the substrate.

## Patentansprüche

1. Substrat mit Durchkontaktierungsstruktur, die Folgendes umfasst:
Substrat, das Folgendes umfasst:
eine Vielzahl von gestapelten Durchkontaktierungen (stacked vias), wobei jede Durchkontaktierung auf einem Aufsatz angeordnet ist; und
wenigstens eine Rückhaltescheibe, die wenigstens einen aus der Vielzahl von gestapelten Durchkontaktierungen umgibt und eine Verformung des Substrats mit Durchkontaktierungsstruktur in der Ebene beschränkt;
**dadurch gekennzeichnet, dass** die Struktur einen isolierenden Spalt zwischen der Rückhaltescheibe und der Durchkontaktierung umfasst.

2. Struktur nach Anspruch 1, wobei die Rückhaltescheibe so eingebettet ist, dass sie zwischen zwei Epoxidschichten angeordnet ist.

3. Struktur nach Anspruch 2, wobei die Rückhaltescheibe aus Kupfer besteht.

4. Struktur nach Anspruch 3, wobei die Rückhaltescheibe im Wesentlichen kreisförmig ist.

5. Struktur nach Anspruch 3, wobei die Rückhaltescheibe quadratisch geformt ist.

6. Struktur nach Anspruch 2, wobei eine Form der Rückhaltescheibe in Abhängigkeit von Konstruktionsparametern und von durch Leiterbahnführungen vorgegebenen Einschränkungen variiert.

7. Struktur nach Anspruch 1, wobei es sich bei den gestapelten Durchkontaktierungen um Durchkontaktierungen aus Kupfer handelt.

8. Verfahren zum Beschränken der Verformung einer gestapelten Durchkontaktierung in der Ebene, wobei das Verfahren das Folgende umfasst:
Erzeugen eines Durchkontaktierungsstapels auf einem Substrat, wobei jede Durchkontaktierung auf einem Aufsatz angeordnet ist;
Erzeugen einer Rückhaltescheibe; und
Einbetten der Rückhaltescheibe so, dass sie den Durchkontaktierungsaufsatz zum Beschränken einer Verformung der gestapelten Durchkontaktierung in der Ebene umgibt;
**gekennzeichnet dadurch, dass** der Schritt des Einbettens ferner das Erzeugen eines isolierenden Spaltes zwischen einem Innendurchmesser der Rückhaltescheibe und dem Durchkontaktierungsaufsatz umfasst.

9. Verfahren nach Anspruch 8, wobei der Schritt des Einbettens das Anordnen der Rückhaltescheibe zwischen zwei Epoxidschichten umfasst.

10. Verfahren nach Anspruch 8, wobei das Erzeugen der Rückhaltescheibe das Herstellen der Rückhaltescheibe aus Kupfer umfasst.

11. Verfahren nach Anspruch 10, wobei das Erzeugen der Rückhaltescheibe ferner das Herstellen einer Kreisscheibe umfasst.

12. Verfahren nach Anspruch 10, wobei der Schritt des Erzeugens der Rückhaltescheibe ferner das Anpassen einer Form der Rückhaltescheibe umfasst, sodass sie sich in den verfügbaren Raum auf dem Substrat einfügt.

## Revendications

1. Structure de trous d'interconnexion en substrat comprenant :
un substrat, lui-même comprenant :
une pluralité de trous d'interconnexion empilés, sachant que chaque trou d'interconnexion est disposé sur un palier ; et
au moins un disque de retenue entourant au moins un de la pluralité de trous d'interconnexion empilés, au moins l'un des disques de retenue limitant la déformation dans le plan de la structure de trous d'interconnexion en substrat ;
**caractérisée en ce que** la structure comprend un interstice isolant entre le disque de retenue et le trou d'interconnexion.

2. Structure selon la revendication 1, sachant que le disque de retenue est incorporé de façon à être disposé entre deux couches de résine.

3. Structure selon la revendication 2, sachant que le disque de retenue est en cuivre.

4. Structure selon la revendication 3, sachant que le disque de retenue est principalement circulaire.

5. Structure selon la revendication 3, sachant que le disque de retenue est de géométrie carrée.

6. Structure selon la revendication 2, sachant qu'une géométrie du disque de retenue varie en fonction des paramètres de conception et des contraintes imposées par les interconnexions.

7. Structure selon la revendication 1, sachant que les trous d'interconnexion empilés sont en cuivre.

8. Procédé servant à limiter la déformation dans le plan d'une pile de trous d'interconnexion et comprenant :
la réalisation d'une pile de trous d'interconnexion sur un substrat, sachant que chaque trou d'interconnexion est disposé sur un palier ;
la réalisation d'un disque de retenue ; et
l'incorporation du disque de retenue de sorte qu'il entoure le palier du trou d'interconnexion pour limiter la déformation dans le plan de la pile de trous d'interconnexion ;
**caractérisé en ce que** l'étape d'incorporation comprend en outre la réalisation d'un interstice isolant entre un diamètre intérieur du disque de retenue et le palier de trou d'interconnexion.

9. Procédé selon la revendication 8, sachant que l'étape d'incorporation comprend la disposition du disque de retenue entre deux couches de résine.

10. Procédé selon la revendication 8, sachant que la réalisation du disque de retenue comprend la réalisation du disque de retenue à partir de cuivre.

11. Procédé selon la revendication 10, sachant que le disque de retenue comprend en outre la réalisation d'un disque circulaire.

12. Procédé selon la revendication 10, sachant que l'étape de réalisation du disque de retenue comprend en outre le modelage sur mesure de ce disque de retenue pour qu'il rentre dans l'espace disponible sur le substrat.
